**Europäisches Patentamt**

**European Patent Office**

**Office européen des brevets**

(11) Numéro de publication : **0 477 077 B1**

(12) **FASCICULE DE BREVET EUROPEEN**

(45) Date de publication du fascicule du brevet :
**25.05.94 Bulletin 94/21**

(21) Numéro de dépôt : **91402450.0**

(22) Date de dépôt : **13.09.91**

(51) Int. Cl.$^5$ : **G01V 1/24,** G01R 13/32,
G01R 13/34

(54) **Synchronisation, sur un événement extérieur de l'échantillonnage de signaux.**

(30) Priorité : **17.09.90 FR 9011527**

(43) Date de publication de la demande :
**25.03.92 Bulletin 92/13**

(45) Mention de la délivrance du brevet :
**25.05.94 Bulletin 94/21**

(84) Etats contractants désignés :
**DE GB IT NL**

(56) Documents cités :
**EP-A- 0 209 928**
**FR-A- 2 538 194**
**GB-A- 2 019 170**

(56) Documents cités :
**GB-A- 2 071 847**
**ELECTRICITE ELECTRONIQUE MODERNE,**
**vol. 44, no. 280, 1974, Paris, FR, pages 17-19;**
**MIQUEL: "L'enregistrement des phénomènes**
**transitoires sur les mèmoires électroniques"**

(73) Titulaire : **INSTITUT FRANCAIS DU PETROLE**
**4, avenue de Bois Préau**
**F-92502 Rueil-Malmaison (FR)**

(72) Inventeur : **Grouffal, Christian**
**14, allée Louis David**
**F-92500 Rueil-Malmaison (FR)**
Inventeur : **Thierry, Gérard**
**9, Villa Blanche**
**F-92000 Nanterre (FR)**

EP 0 477 077 B1

## Description

La présente invention a pour objet une méthode et un dispositif pour synchroniser avec un signal de référence marquant un événement extérieur, l'échantillonnage de signaux de mesure par un ensemble de numérisation du type à sur-échantillonnage.

Un tel ensemble de numérisation trouve des applications dans tous les domaines où l'on doit échantillonner par exemple différents signaux mesurés, au moyen de plusieurs chaînes d'acquisition différentes en imposant que les séries d'échantillons prélevés soient sensiblement en synchronisme les unes par rapport aux autres. C'est le cas notamment dans le domaine de l'exploration sismique où l'on veut fixer pour un système d'acquisition un instant de référence par rapport auquel on compte des intervalles de temps de propagation.

L'instant de référence initial généralement choisi est l'instant de déclenchement d'une source d'ondes sismiques. Les ondes émises se propagent dans le sous-sol et sont reçues par des capteurs sismiques répartis à la surface du sol par exemple. Les signaux délivrés par ces capteurs sont transmis à un laboratoire central de commande et d'enregistrement, soit directement, soit suivant des méthodes plus récentes, par l'intermédiaire de dispositifs d'acquisiton répartis sur le terrain. Chacun d'eux est adapté à amplifier, filtrer, numériser et mémoriser tous les signaux captés consécutivement à chaque déclenchement de la source. Après chaque cycle d'émission-réception ou après un certain nombre d'entre eux, les données mémorisées sont centralisées dans le laboratoire. Des sytèmes d'acquisition sismiques sont décrits par exemple dans les brevets FR 2 511 772 (US 4 583 206) ou FR 2 538 194 (US 4 628 494).

Dans chaque appareil d'acquisition, les signaux sismiques sont appliqués à une chaîne d'acquisition. Une structure courante de chaîne d'acquisition comporte un pré-amplificateur à gain fixe, un filtre passe-haut, un filtre passe-bas anti-repliement (anti-aliasing) et un convertisseur analogique-numérique (C.A.N) précédé d'un amplificateur à gain variable (A.G.V) dont le gain est adapté à la dynamique du convertisseur. Les convertisseurs délivrent généralement des mots numériques de 12 à 16 bits qui sont complétés par un mot de 4 bits traduisant sous forme binaire le gain appliqué à chaque échantillon numérisé. Cette structure classique, analogique pour sa plus grande partie, présente de nombreux inconvénients. Un amplificateur à gain variable est difficile à régler et sujet à des dérives thermiques. Le prix d'un amplificateur stable est donc relativement élévé. Il en est de même du filtre d'anti-repliement du fait qu'il faut généralement en prévoir plusieurs commutables adaptés chacun à un pas possible d'échantillonnage.

Beaucoup des inconvénients d'une chaîne d'acquisition du type analogique, sont évités par la technique dite de sur-échantillonnage. La structure d'une telle chaîne est simplifiée. La chaîne d'acquisition se réduit à un préamplificateur, un filtre passe-haut, un convertisseur à sur-échantillonnage et à un filtre numérique. Ce type de convertisseur a une dynamique de conversion plus étendue, ce qui rend possible la suppression de l'amplificateur à gain variable (A.G.V) et les fonctions du filtre anti-repliement sont remplies par le filtre numérique qui suit le convertisseur C.A.N..

La technique du sur-échantillonnage est mise en oeuvre au moyen d'un convertisseur analogique-numérique produisant des mots numériques d'un format plus réduit qu'un convertisseur classique mais capable d'échantillonner des signaux à une fréquence beaucoup plus élevée. La dynamique normale est rétablie en appliquant les signaux issus du convertisseur à un filtre numérique spécial qui, outre ses fonctions de filtrage, est adapté à sommer un nombre déterminé d'échantillons avec des pondérations appropriées comme il est bien connu des spécialistes. Un convertisseur à sur-échantillonnage produit par exemple des mots de 1 bit à une fréquence de quelques centaines de kHz. A la suite de l'opération de sommation et de filtrage qu'il effectue sur un grand nombre de ces mots d'un bit, le filtre numérique produit par exemple des mots numériques de 20 bits au moins à une fréquence d'échantillonnage dans une plage de fréquence autour de 1 KHz (125 Hz à 4 kHz par exemple).

Un convertisseur analogique-numérique numérise des séries d'échantillons analogiques prélevés sur un signal à des instants fixés par une horloge interne. Ce n'est pas un inconvénient quand le convertisseur fonctionne isolément. Cela le devient dans tous les cas où l'on cherche à fixer avec précision un instant initial de référence par rapport auquel une séquence d'événements est repérée et surtout quand on doit procéder à des acquisitions de signaux par un ensemble de convertisseurs différents. Dans les opérations de prospection sismique notamment, les ondes sismiques émanant du sous-sol à la suite de l'émission par une source de signaux sismiques, sont captées par une multiplicité de capteurs et sont converties en échantillons numérisés par un ensemble souvent important de chaînes d'acquisition différentes pourvues chacune d'un convertisseur analogique-numérique. On choisit un instant de référence, généralement celui où la source sismique est déclenchée et l'on cherche à caler par rapport à cet instant le premier échantillon prélevé par les différents convertisseurs, sur chacun des signaux captés. Si l'instant d'échantillonnage de chaque convertisseur ne dépend que d'une horloge interne, il n'a donc aucune raison d'être synchronisé sur l'événement extérieur choisi comme référence. Il s'ensuit donc un certain retard aléatoire (ou jitter) qui est généralement différent d'une chaîne d'acquisition à une autre. La conséquence en est un manque de synchronisation qui est très gênant quand on doit procéder à des combinaisons de signaux reçus et acquis par des chaînes d'acquisition différentes, comme c'est le cas généralement dans tous les traitements sismiques classiques.

Le dispositif selon l'invention permet de synchroniser avec un signal de référence marquant un événement extérieur, l'échantillonnage de signaux de mesure par un ensemble de numérisation pourvu d'un convertisseur analogique-numérique du type à sur-échantillonnage associé à une horloge produisant des signaux de synchronisation et un filtre numérique adapté à produire à partir des signaux de mesure et avec une période fixe, multiple de la période d'échantillonnage dudit convertisseur, une série d'échantillons validés résultant chacun de la sommation d'un nombre déterminé n d'échantillons issus du convertisseur-analogique numérique, et d'éviter ainsi les inconvénients ci-dessus mentionnés.

Il est caractérisé en ce qu'il comporte des moyens de décalage pour forcer la production par le filtre numérique, d'une série d'échantillons validés, le premier d'entre eux correspondant à un échantillon prélevé sur le signal d'entrée avec un décalage indépendant de l'instant de référence.

Les moyens de décalage sont adaptés par exemple à forcer la production par le filtre dudit premier échantillon validé, avec un décalage au plus égal à une fraction définie de ladite période fixe, cette fraction étant par exemple égale à au moins une période d'échantillonnage.

Les moyens de décalage pour forcer l'émission par le filtre numérique, du premier échantillon validé, comportent par exemple une mémoire pour un nombre N d'échantillons supérieur au nombre n d'échantillons à sommer par le filtre numérique pour produire tout échantillon validé, et un ensemble de contrôle adapté, à la réception dudit signal de référence, à commander l'extraction sélective de n échantillons choisis en fonction de l'instant d'arrivée dudit signal de référence et leur transfert dans le filtre numérique, de manière que le premier échantillon validé postérieurement au signal de référence produit par le filtre numérique, corresponde à un échantillon prélevé sur les signaux de mesure avec un décalage au plus égal à un nombre défini de périodes d'échantillonnage.

On utilise par exemple un ensemble de contrôle adapté par exemple à commander l'extraction des n échantillons précédent l'arrivée du signal de référence et à les transférer dans ledit filtre numérique.

On peut utiliser aussi un ensemble de contrôle adapté à commander l'extraction de n échantillons distribués dans le temps de part et d'autre de l'instant d'arrivée du signal de référence.

La mémoire étant pourvue d'un pointeur d'écriture et d'un pointeur de lecture, l'ensemble de contrôle comporte par exemple un compteur pour mémoriser le nombre de périodes d'échantillonnage dans un intervalle de temps t au plus égal à une desdites périodes fixes, permettant de repérer l'instant d'arrivée du signal de référence, et des moyens pour décaler lesdits pointeurs l'un par rapport à l'autre en fonction du nombre mémorisé par ledit compteur, de manière à sélectionner les échantillons formant le premier échantillon validé postérieurement à l'instant de référence.

Comme mémoire, on utilise par exemple une mémoire du type tournante F.I.F.O. agencée pour fonctionner en ligne à retard, le retard appliqué aux échantillons transmis au filtre numérique étant au plus égal à la durée d'échantillonnage des N échantillons dans la mémoire.

Avec le dispositif selon l'invention, tel qu'il est défini ci-dessus, on peut obtenir une synchronisation optimale puisque le premier échantillon validé de chaque signal à mesurer n'est séparé en temps du signal de référence que d'un intervalle très réduit inférieur à la période d'échantillonnage et toujours le même sensiblement.

La méthode selon l'invention permet de synchroniser avec un signal de référence commun marquant un événement extérieur, l'échantillonnage de signaux de mesure respectivement par une pluralité de dispositifs de numérisation de signaux comportant chacun un convertisseur analogique-numérique du type à sur-échantillonnage associés chacun à une horloge produisant des signaux de synchronisation et un filtre numérique adapté à produire à partir des signaux de mesure et avec une période fixe (T), une série d'échantillons validés résultant chacun de la sommation d'une suite de n échantillons successifs issus du convertisseur-analogique numérique et obtenus par sur-échantillonnage. Elle est caractérisée en ce qu'elle comporte

- le stockage d'un nombre déterminé N d'échantillons plus grand que le nombre n de chaque suite d'échantillons issus de chacun desdits convertisseurs analogique-numérique avant leur application au filtre numérique correspondant,

- la sélection parmi les N échantillons de chaque signal de mesure stockés en permanence d'une suite de n échantillons successifs chronologiquement décalée, telle que l'échantillon validé correspondant issu de chaque filtre numérique, correspond à un échantillon prélevé sur chaque signal avec un décalage indépendant de l'instant de référence et sensiblement le même pour tous les dispositifs de numérisation.

Le décalage chronologique appliqué pour sélectionner chaque suite est obtenu par exemple par une mesure du temps séparant les instants d'émission des échantillons validés de l'instant d'arrivée du signal de référence.

Par la méthode selon l'invention, on rend sensiblement synchrone des séries d'échantillons ce qui facilite notamment toutes les opérations de traitement impliquant des combinaisons de séries différentes.

D'autres caractéristiques et avantages du dispositif selon l'invention apparaîtront mieux à la lecture de la description ci-après d'un mode de réalisation décrit à titre d'exemple non limitatif, en se référant aux dessins annexés où :

- la Fig.1 montre schématiquement la structure d'un convertisseur analogique-numérique à sur-échantillonnage d'un type connu;
- la Fig.2A montre un premier chronogramme d'échantillonnage d'un signal quelconque à mesurer;
- la Fig.2B montre un deuxième chronogramme d'échantillonnage du même signal, analogue au premier mais décalé dans le temps;
- la fig.3 montre schématiquement le dispositif selon l'invention; et
- les Fig.4A à 4H montrent différents chronogrammes permettant de visualiser la séquence de fonctionnement du dispositif de la Fig.2.

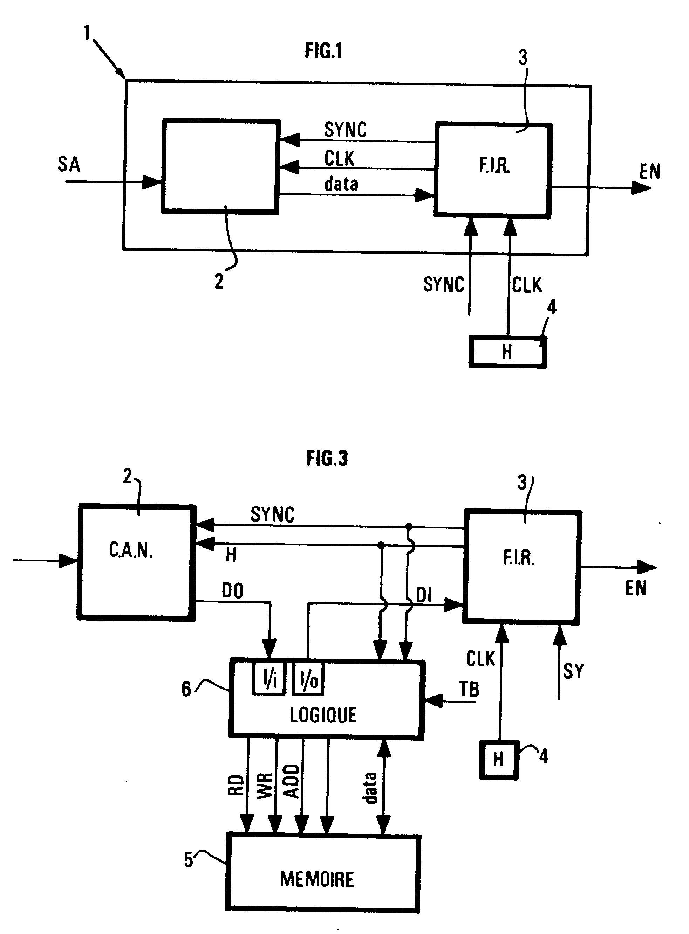

Le dispositif 1 d'un type connu représenté à la Fig.1, délivre par exemple des mots numériques de N bits avec une fréquence d'échantillonnage f en utilisant la combinaison en série de deux circuits intégrés 2, 3 que l'on peut trouver dans le catalogue de plusieurs fabricants, et basé sur l'utilisation de modulateurs delta-sigma. Le premier élément 2 est un convertisseur délivrant en série des mots numériques d'un format plus réduit p avec une fréquence d'échantillonnage F= k.f ou k est un entier plus grand que 1. Le deuxième élément 3 est un filtre numérique du type F.I.R (pour Finite Impulse Response) qui fait une moyenne sur un certain nombre d'échantillons issus successivement du convertisseur 2. A titre d'exemple, le convertisseur 2 produit des mots numériques de 1 bit à une fréquence de 256 kHz par exemple et le filtre numérique somme un très grand nombre d'échantillons successifs pour produire des mots numériques de 20 bits au moins à une fréquence de 1 KHz. La fréquence d'échantillonnage et les ordres de sommation successifs transmis au filtre numérique 3 sont produits par une horloge 4 délivrant des signaux de synchronisation.

Le dispositif 1 procédant pour former des mots de N bits à une sommation d'un certain nombre d'échantillons obtenus par sur-échantillonnage, chaque échantillon qu'il produit est décalé dans le temps par rapport aux instants fixés par son horloge interne.

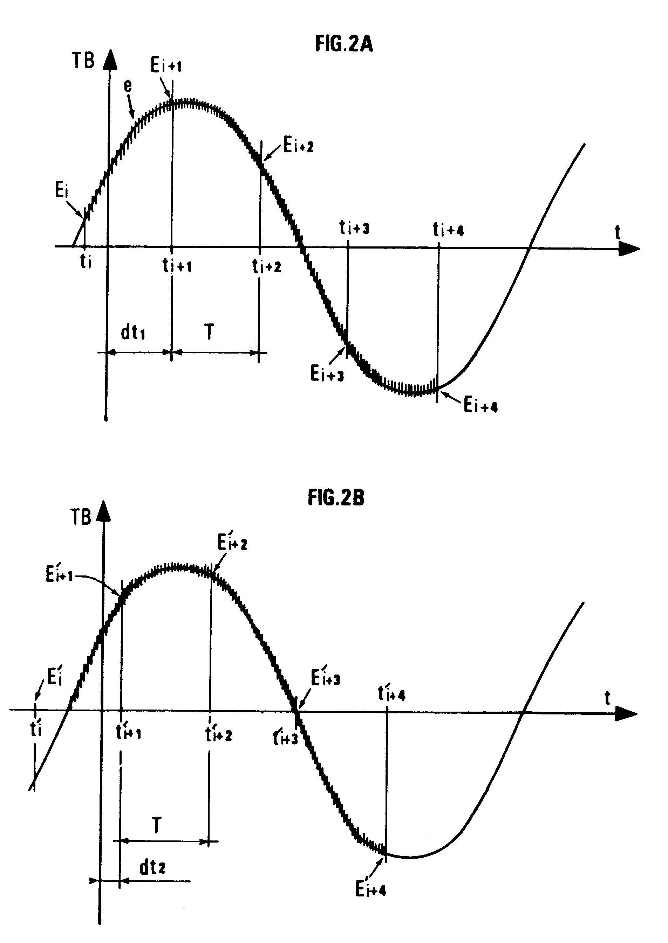

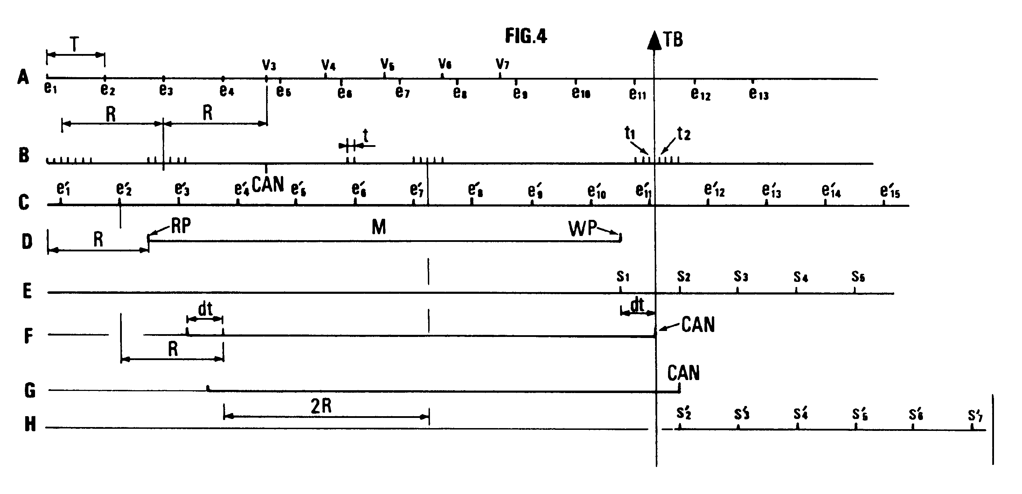

Un tel dispositif fonctionne correctement dans tous les cas où l'on ne cherche pas à imposer un calage précis d'une séquence d'échantillons numérisés par rapport à un événement extérieur quel que soit l'instant où il survient. Sur la Fig.2, on voit que les échantillons successifs Ei, Ei+1... Ei+4 qui sont le résultat chacun de la sommation d'un ensemble d'échantillons e, sont produits à la sortie du filtre numérique 3 avec une période T aux instants successifs ti, ti+1... ti+4 qui sont imposés par l'horloge interne 4. Un événement extérieur peut survenir à tout instant TB compris entre deux échantillons quelconques successifs, Ei et Ei+1 par exemple et dans ce cas, l'intervalle de temps dt1 entre l'instant TB et l'instant ti+1 de production du premier échantillon postérieur au signal TB, peut prendre n'importe quelle valeur comprise entre 0 et T. Le même signal issu d'un dispositif 1 identique fonctionnant avec une horloge interne non synchronisée avec la première, produit (Fig.3) des séries d'échantillons E'i...E'i+4 etc de même période T mais à des instants différents t'i... t'i+4 etc. L'intervalle de temps dt2 entre l'instant TB et l'instant t'i+1 par exemple de production du premier échantillon qui lui est postérieur, sera différent. Si l'on utilise un nombre important de tels dispositifs, on obtient des séries d'échantillons dispersées les unes par rapport aux autres et par rapport à l'instant TB imposé.

Le dispositif selon l'invention comporte un convertisseur 2, un filtre numérique 3 et une horloge 4 analogues à ceux du dispositif de la Fig.1. Le filtre 3 reçoit sur une première entrée un signal de synchronisation SY et sur une deuxième entrée un signal d'horloge CLK.

Il comporte en outre une mémoire 5 de capacité N déterminée et une unité logique de commande 6 qui, on va le voir vont permettre le recalage sur échantillons validés issus du filtre numérique 3.

Le signal d'horloge CLK ainsi qu'un signal de synchronisation SYNC sont appliqués à des entrées du filtre 3. Les signaux SYNC définissent les instants de production par le filtre 3, des échantillons validés. Des connexions permettent l'application de signaux d'horloge H dérivés des signaux CLK et SY respectivement et de synchronisation SYNC, au convertisseur 2 et à l'unité logique 6. La sortie du convertisseur 2 produisant bit à bit les "sur-échantillons" successifs DO est connectée à une porte d'entrée I/i de l'unité logique 6. Une porte de sortie I/o de l'unité logique produisant bit à bit des sur-échantillons DI est connectée à une entrée du filtre numérique 3. L'unité logique 6 comporte une entrée pour l'application du signal de référence TB. Des liaisons entre l'unité logique 6 et la mémoire 5 permettent l'application à celle-ci de signaux de commande de lecture RD, d'écriture WR et de mots numériques ADD désignant les adresses de la mémoire impliquées dans les échanges, et en retour le transfert vers l'unité logique des données DATA extraites. Dans l'unité logique 6, un compteur (non représenté) est alimenté par le signal d'horloge H et il est remis à zéro à chaque fois qu'un nouvel échantillon validé est produit par le filtre numérique 3. Le contenu de ce compteur représente en permanence l'intervalle de temps dt écoulé depuis la production du dernier échantillon validé produit par le dispositif de la mémoire 5.

L'unité logique 6 a pour fonction de piloter l'écriture des bits produits par le convertisseur 2 dans la mémoire 5 et leur transfert sélectif vers le filtre 3.

La mémoire 5 est du type à mémoire tournante F.I.F.O (pour First-In-First-Out). Elle est gérée par un pointeur d'écriture WP pour désigner l'adresse de la mémoire 5 où va être écrit un nouvel échantillon issu du convertisseur 2, et un pointeur de lecture RP désignant l'adresse où doit être prélevé l'échantillon à tranférer vers le filtre 3. Chaque nouvelle écriture s'accompagne d'un décalage du pointeur vers l'adresse suivante de la mémoire et, si l'adresse de fin de mémoire est atteinte, le retour à l'adresse de début. Le même décalage du pointeur de lecture à l'adresse suivante se produit à chaque nouvelle lecture d'un échantillon mémorisé avec un retour en tête de la mémoire 5 quand il est parvenu à la dernière adresse de celle-ci.

Dans le cas particulier où les pointeurs de lecture et d'écriture désignent la même adresse, la mémoire agit comme une ligne à retard. La donnée la plus ancienne est lue et à sa place est inscrite une nouvelle donnée. Le retard appliqué est fonction de la taille de la mémoire 5.

Le convertisseur 2 (C.A.N.) sur-échantillonne les signaux avec une période t (Fig. 4B). Des échantillons sont prélevés sur les signaux à mesurer avec une période T multiple de la période t (Fig.4A) et le filtre numérique 3 délivre les échantillons numérisés V3, V4 etc avec un certain retard R inhérent au principe de fonctionnement et qui est égal à un certain nombre de périodes de sur-échantillonnage t (de l'ordre de 25 par exemple). Le signal de référence TB arrive à un instant qui, dans un mode de fonctionnement autonome est situé entre deux instants quelconques (e11 et e12 sur la Fig. 4). On veut qu'un échantillon e'11 soit prélevé sur le signal à mesurer à un des instants t1 ou t2 bornant l'intervalle de sur-échantillonnage où arrive le signal de référence TB (Fig.4C). La mémoire 5 est symbolisée sur la Fig.4D par son contenu M de sur-échantillons en temps. Sur la Fig. 4D, elle est positionnée en rapport avec la série d'échantillons de la Fig. 4A. Les bits (DI) qui en sortent vers le filtre 3, sont décalés de l'intervalle R par rapport à l'instant d'échantillonnage de e1. Ceux qui y rentrent, issus du convertisseur 2 (C.A.N) sont décalés du contenu en temps de la mémoire 5. Cet intervalle mémoire M se déplace à chaque impulsion de sur-échantillonnage de période t.

Le dispositif fonctionne de la manière suivante :
1) Avant l'arrivée du signal TB, l'unité logique est adaptée à gérer la mémoire 5 comme une ligne à retard i.e les pointeurs de lecture et d'écriture désignent la même adresse. A chaque cycle de lecture/écriture, l'unité logique 6 pilote l'extraction du bit le plus ancien à l'adresse commune désignée par les pointeurs RP, WP et son transfert vers le filtre 3 et ensuite l'écriture à la même adresse du nouveau bit entrant fourni par le convertisseur 2 suivie du décalage du pointeur commun à l'adresse suivante.

- A chaque sortie (période T) d'un nouvel échantillon validé par le filtre 3, le compteur dans l'unité logique 6 qui fournit la variable dt est remis à zéro.

2) L'arrivée du signal TB a pour effet de figer le contenu du compteur interne à l'unité logique 6, qui indique alors le temps écoulé entre le dernier échantillon validé issu du filtre 3 (s1 sur la Fig.4E) et l'instant d'arrivée du signal TB. L'unité logique commande alors le décalage de dt rangs du pointeur de lecture RP par rapport au pointeur d'écriture WP (cf. Fig.4F), et l'on a :

$$RP = WP + dt$$

ou bien

$$RP = WP + dt - K$$

si RP devient supérieur à K.

3) Entre l'instant TB et la délivrance par le filtre 3 d'un échantillon validé, à chaque impulsion de l'horloge CLK, l'unité logique pilote :

a) l'écriture d'un bit fourni par le convertisseur 2 à l'adresse indiquée par le pointeur écriture et la translation d'un rang de celui-ci; et

b) le transfert vers le filtre 3 du bit à l'adresse indiquée par le pointeur de lecture RP sans décalage ultérieur de ce même pointeur qui n'est pas modifié.

Ceci est traduit sur la Fig.4G par un décalage de l'intervalle mémoire M, le pointeur de lecture n'étant pas modifié.

4) A partir de l'instant où le filtre 3 produit un échantillon et, à chaque impulsion de l'horloge de sur-échantillonnage CLK, l'unité logique 6 pilote un cycle normal de lecture/écriture avec une écriture d'un nouveau bit produit par le convertisseur 2 à l'adresse indiquée par le pointeur de lecture, un décalage de ce pointeur, une lecture du bit à l'adresse désignée par le pointeur de lecture et un décalage de celui-ci. Du fait du recalage les échantillons e'1, e'2...e'7 (Fig.4C) qui sont dans l'intervalle de durée 2R antérieur à l'adresse du pointeur de lecture, ne peuvent être validés. Les échantillons numérisés validés s'8, s'9 etc (Fig.4H) correspondent aux bit mémorisés postérieurement à la fin de l'intervalle 2R précédent.

On voit que par ce décalage du pointeur de lecture RP vers des bits plus récemment écrits dans la mémoire 5, les bits sommés par le filtre 3 vont correspondre à un échantillons analogique (en l'occurence e'11) retardé par rapport à l'échantillon correspondant obtenu en fonctionnement autonome (en l'occurence e11) pour être le plus près possible du signal TB.

Si donc plusieurs dispositifs (comme celui qui vient d'être décrit) et fonctionnant avec la même fréquence d'horloge, reçoivent le même signal TB, ils vont délivrer respectivement des séries d'échantillons validés qui seront tous sensiblement synchrones, à au plus une période de sur-échantillonnage près t, quelques micro-secondes dans la pratique.

On choisit de préférence de recaler la série d'échantillons prélevés (e'11, e'12 etc) sur les instants T1 ou T2 (Fig.4B) encadrant immédiatement l'instant TB.

On ne sortirait pas du cadre de l'invention néanmoins en choisissant pour une application particulière, un recalage différent par rapport à cet instant TB mais commun à tous les dispositifs.

Les valeurs numériques indiquées par les fréquences de sur-échantillonnage et de production des échantillons validés ainsi que pour le format des mots numériques ne sont pas limitatifs. Le principe décrit de mémorisation et décalage des sur-échantillons peut être appliqué à n'importe quelle combinaison de moyens de sur-échantillonnage et de filtrage numérique et dans d'autres domaines d'application sans sortir du cadre de l'invention.

## Revendications

1. Dispositif pour synchroniser avec un signal de référence (TB) marquant un événement extérieur, l'échantillonnage de signaux de mesure par au moins un ensemble de numérisation comportant un convertisseur analogique-numérique (2) du type à sur-échantillonnage associé à une horloge (4) produisant un signal de synchronisation (CLK) et à un filtre numérique (3) adapté à produire, à partir des signaux de mesure et avec une période fixe (T) multiple de la période d'échantillonnage, une série d'échantillons validés (s1, s2...) résultant chacun de la sommation d'un nombre déterminé n d'échantillons issus du convertisseur-analogique numérique (2), caractérisé en ce qu'il comporte des moyens de décalage (5, 6) pour forcer la production par le filtre numérique, d'une série d'échantillons validés, le premier d'entre eux (s'11) correspondant à un échantillon (e'11) prélevé sur le signal d'entrée avec un décalage indépendant de l'instant de référence (TB).

2. Dispositif selon la revendication 1, caractérisé en ce que lesdits moyens de décalage sont adaptés à forcer la production par le filtre dudit premier échantillon validé, avec un décalage au plus égal à une fraction définie de ladite période fixe.

3. Dispositif selon la revendication 1 ou 2, caractérisé en ce que les moyens de décalage pour forcer l'émission par le filtre numérique, du premier échantillon validé, comportent une mémoire (5) pour un nombre N d'échantillons supérieur au nombre n d'échantillons à sommer par le filtre numérique (3) pour produire tout échantillon validé et un ensemble de contrôle (6) adapté, à la réception dudit signal de référence (TB), à commander l'extraction sélective de n échantillons choisis en fonction de l'instant d'arrivée dudit signal de référence et leur transfert dans le filtre numérique, de manière que le premier échantillon (s'11) validé postérieurement au signal de référence produit par le filtre numérique, corresponde à un échantillon (e'11) prélevé sur les signaux de mesure avec un décalage au plus égal à un nombre défini de périodes d'échantillonnage (t).

4. Dispositif selon la revendication 3, caractérisé en ce que l'ensemble de contrôle (6) est adapté à commander l'extraction des n échantillons précédent l'arrivée du signal de référence et à les transférer dans ledit filtre numérique.

5. Dispositif selon la revendication 3, caractérisé en ce que l'ensemble de contrôle (6) est adapté à commander l'extraction de n échantillons distribués dans le temps de part et d'autre de l'instant d'arrivée du signal de référence.

6. Dispositif selon l'une des revendications 3 à 5, caractérisé en ce que la mémoire (5) étant pourvue d'un pointeur d'écriture et d'un pointeur de lecture, l'ensemble de contrôle (6) comporte un compteur pour mémoriser le nombre de périodes (t) d'échantillonnage dans un intervalle de temps et au plus égal à une desdites périodes fixes (T), permettant de repérer l'instant d'arrivée du signal de référence, et des moyens pour décaler lesdits pointeurs l'un par rapport à l'autre en fonction du nombre mémorisé par ledit compteur, de manière à sélectionner les échantillons formant le premier échantillon validé postérieurement à l'instant de référence.

7. Dispositif selon l'une des revendications 3 à 6, caractérisé en ce que la mémoire (5) est du type mémoire tournante F.I.F.O agencée pour fonctionner en ligne à retard, le retard appliqué aux échantillons transmis au filtre numérique étant au plus égal à la durée d'échantillonnage des N échantillons dans la mémoire.

8. Méthode pour synchroniser avec un signal de référence commun marquant un événement extérieur, l'échantillonnage de signaux de mesure respectivement par une pluralité d'ensembles de numérisation de signaux comportant chacun un convertisseur analogique-numérique (2) du type à sur-échantillonnage associés chacun à une horloge (4) produisant des signaux de synchronisation et un filtre numérique (3) adapté à produire à partir des signaux de mesure et avec une période fixe (T), une série d'échantillons validés résultant chacun de la sommation d'une suite de n échantillons successifs issus du convertisseur-analogique numérique (2) et obtenus par sur-échantillonnage, caractérisée en ce qu'elle comporte

- le stockage d'un nombre déterminé N d'échantillons plus grand que le nombre n de chaque suite d'échantillons issus de chacun desdits convertisseurs analogique-numérique avant leur application au filtre numérique correspondant,

- la sélection parmi les N échantillons de chaque signal de mesure stockés en permanence d'une suite de n échantillons successifs chronologiquement décalée, telle que l'échantillon validé correspondant issu de chaque filtre numérique, correspond à un échantillon prélevé sur chaque signal avec un décalage indépendant de l'instant de référence et sensiblement le même pour tous les dispositifs de numérisation.

9. Méthode selon la revendication 8, caractérisée en ce que le décalage chronologique appliqué pour sélectionner chaque suite est obtenu par une mesure du temps séparant les instants d'émission des échantillons validés de l'instant d'arrivée du signal de référence.

**Patentansprüche**

1. Vorrichtung zum Synchronisieren der Meßsignale-Abtastschaltung mit einem ein äußeres Ereignis kennzeichnenden Bezugssignal (TB) durch wenigstens eine Digitalisierungseinheit, umfassend einen Analog-Digital-Wandler (2) vom Typ einer Signal-Über-Abtastschaltung (Oversampling), die mit einem Taktgeber (4), welcher ein Synchronisationssignal (CLK) erzeugt, und mit einem numerischen Filter (3) verbunden ist, welcher geeignet ist, auf der Grundlage von Meßsignalen und in einem bestimmten, zu dem Signal-Abtastungszeitintervall vielfachen Zeitintervall (T) eine Reihe von gültigen Abtastungen (s1, s2, ...) zu erzeugen, wobei jede aus der Summierung einer bestimmten Anzahl n von Abtastungen, die von dem Analog-Digital-Wandler (2) stammen, resultieren, dadurch gekennzeichnet, daß sie Verschiebungsmittel (5, 6) umfaßt, um die Erzeugung von einer Reihe von gültigen Abtastungen durch den numerischen Filter zu forcieren, wobei die erste unter ihnen (s'11) einer Abtastung (e'11) entspricht, die dem Eingangssignal mit einer von dem Bezugszeitpunkt (TB) unabhängigen Verschiebung vorangeht.

2. Vorrichtung nach Anspruch 1, dadurch gekennzeichnet, daß die Verschiebungsmittel geeignet sind, die Erzeugung der ersten gültigen Abtastung durch den Filter mit einer Verschiebung höchstens gleich einem definierten Bruchteil des bestimmten Zeitintervalls zu forcieren.

3. Vorrichtung nach Anspruch 1 oder 2, dadurch gekennzeichnet, daß die Verschiebungsmittel zur Forcierung der Aussendung der ersten gültigen Abtastung durch den numerischen Filter einen Speicher (5) für eine Anzahl N von Abtastungen größer einer Anzahl n von durch den numerischen Filter (3) zu summierenden Abtastungen, um jede gültige Abtastung zu erzeugen, und eine Kontroll- bzw. Steuereinheit (6) umfassen, die zur Aufnahme des Bezugssignals (TB) geeignet ist, um das selektive Auslesen von n Abtastungen, die im Eingangszeitpunkt des Bezugssignals und ihrer Übermittlung in den numerischen Filter gewählt sind, zu steuern, derart, daß die erste gültige Abtastung (s'11) zu dem durch den numerischen Filter erzeugten Bezugssignal nachfolgend einer Abtastung (e'11) entspricht, die den Meßsignalen mit einer Verschiebung höchstens gleich einer definierten Anzahl von Signal-Abtastungszeitintervallen (t) vorangeht.

4. Vorrichtung nach Anspruch 3, dadurch gekennzeichnet, daß die Kontroll- bzw. Steuereinheit (6) geeignet ist, das Auslesen von n Abtastungen, die dem Eingang des Bezugssignal vorausgehen, zu steuern und in den numerischen Filter zu übermitteln.

5. Vorrichtung nach Anspruch 3, dadurch gekennzeichnet, daß die Kontroll- bzw. Steuereinheit (6) geeignet ist, das Auslesen von Abtastungen, die in der Zeit beidseits des Eingangszeitpunktes von dem Bezugssignal verteilt sind, zu steuern.

6. Vorrichtung nach einem der Ansprüche 3 bis 5, dadurch gekennzeichnet, daß der Speicher (5) mit einem Schreibmarkierer und einem Lesemarkierer versehen ist, die Kontroll- bzw. Steuereinheit (6) einen Zähler umfaßt, um die Anzahl der Signal-Abtastungszeitintervalle (t) in einem Zeitintervall und höchstens gleich einer der bestimmten Zeitintervalle (T) zu speichern, die ermöglichen, den Eingangszeitpunkt des Bezugssignals zu kennzeichnen, und Mittel zum Verschieben der Markierer in gegenseitigen Bezug zueinander in Funktion von der durch den Zähler gespeicherten Anzahl, derart, um die Abtastungen auszuwählen, die die erste gültige Abtastung dem Bezugszeitpunkt nachfolgend bilden.

7. Vorrichtung nach einem der Ansprüche 3 bis 6, dadurch gekennzeichnet, daß der Speicher (5) vom Typ eines Drehspeichers F.I.F.O. ist, der eingerichtet ist, um in Reihe mit Verzögerung zu funktionieren, wobei die Verzögerung, die auf die an den numerischen Filter übermittelten Abtastungen angewendet ist, höchstens gleich der Signal-Abtastungsdauer der N Abtastungen in dem Speicher sind.

8. Verfahren zum Synchronisieren der Meßsignale-Abtastschaltung mit einem gemeinsamen ein äußeres Ereignis kennzeichnenden Bezugssignal jeweils durch eine Vielzahl von Signal-Digitalisierungseinheiten, jede umfassend einen Analog-Digital-Wandler (2) vom Typ einer Signal-Über-Abtastschaltung (Oversampling), die jede mit einem Taktgeber (4), welcher Synchronisationssignale erzeugt, und einem numerischen Filter (3) verbunden sind, welcher geeignet ist, auf der Grundlage von Meßsignalen und in einem bestimmten Zeitintervall (T) eine Reihe von gültigen Abtastungen zu erzeugen, die jeweils aus der Summierung einer Folge von n Abtastungen, die aufeinanderfolgen, von dem Analog-Digital-Wandler (2) stammen und durch Signal-Über-Abtastschaltung (Oversampling) erhalten werden, resultieren, dadurch gekennzeichnet, daß es umfaßt:
    - die Speicherung einer bestimmten Anzahl N von Abtastungen größer als die Anzahl n von jeder Folge von Abtastungen, die jede von den Analog-Digital-Wandlern vor ihrer Anlegung an den entsprechenden numerischen Filter stammen,
    - die Auswahl unter den N Abtastungen von jedem Meßsignal, die dauernd aus einer Folge von n nachfolgenden Abtastungen, welche zeitlich verschoben ist, gespeichert werden, derart, daß die gültige Abtastung, die zu der von jedem numerischen Filter stammenden korrespondiert, einer Abtastung entspricht, die jedem Signal mit einer von dem Bezugszeitpunkt unabhängigen und für sämtliche Digitalisierungsanordnungen im wesentlichen gleichen Verschiebung vorangeht.

9. Verfahren nach Anspruch 8, dadurch gekennzeichnet, daß die zeitliche Verschiebung, die angewendet wird, um jede Folge auszuwählen, durch eine Zeitmessung erhalten wird, welche die Aussendungszeitpunkte der gültigen Abtastungen von dem Eingangszeitpunkt des Bezugssignals trennt.

## Claims

1. A device for synchronising with a reference signal (TB) marking an external event the sampling of measurement signals by means of at least one digitisation assembly having an analog-to-digital convertor (2) of the over-sampling type associated with a clock (4) producing a synchronisation signal (CLK) and a digital filter (3) programmed to produce from measurement signals and with a fixed period (T) that is a multiple of the sampling period a series of validated samples (s1, s2...) each resulting in the summation of a determined number n of samples emitted by the analog-to-digital convertor (2), characterised in that it has phase shifting means (5, 6) for forcing the digital filter to produce a series of validated samples, the first of them (s'11) corresponding to a sample (e'11) taken on the input signal with a phase independent of the reference instant (TB).

2. A device in accordance with claim 1, characterised in that the phase shifting means are adapted to force the filter to produce the first validated sample with a shift equal at most to a defined fraction of the fixed period.

3. A device in accordance with claim 1 or 2, characterised in that the phase shifting means for forcing the digital filter to emit the first validated sample has a memory (5) for a number N of samples greater than the number n of samples to be summated by the digital filter (3) to produce any validated sample and a control unit (6) programmed, on receipt of the reference signal (TB), to command the selective extraction of n samples chosen in relation to the instant at which the reference signal arrived and transfer them to the digital filter so that the first sample (s'11) validated after the reference signal produced by the digital filter corresponds to a sample (e'11) taken on the measurement signals with a shift at least equal to a defined number of sampling periods (t).

4. A device in accordance with claim 3, characterised in that the control unit (6) is programmed to command the extraction of the n samples preceding the arrival of the reference signal and to transfer them to the digital filter.

5. A device in accordance with claim 3, characterised in that the control unit (6) is programmed to command the extraction of n signals spaced over the time on either side of the instant at which the reference signal arrived.

6. A device in accordance with one of claims 3 to 5, characterised in that the memory (5) is provided with a writing pointer and a reading pointer, the control unit (6) has a counter to memorise the number of periods (t) of sampling in an interval of time and at most equal to one of the fixed periods (T), permitting the instant at which the reference signal arrives to be located, and means for shifting the pointers in relation to each other depending on the number memorised by the counter, so as to select the samples making up the first sample validated after the reference instant.

7. A device in accordance with one of claims 3 to 6, characterised in that the memory (5) is of the revolving F.I.F.O. type designed to operate on line with a delay, the delay applied to the samples transmitted to the digital filter being at most equal to the sampling duration of N samples in the memory.

8. A method for synchronising with a common reference signal marking an external event the sampling of measurement signals respectively by a plurality of digitisation units each having an analog-to-digital convertor (2) of the over-sampling type each associated with a clock (4) producing synchronisation signals and a digital filter (3) programmed to produce from the measurement signals and with a fixed period (T) a series of validated samples each resulting from the summation of a series of n successive samples emitted by the analog-to-digital convertor (2) and obtained by over-sampling, characterised in that it involves

   - storing a determined number N of samples greater than the number n of each series of samples emitted by each of the analog-to-digital convertors before they are applied to the corresponding digital filter,
   - selecting from the N samples of each measurement signal stored permanently a series of n successive samples chronologically shifted, so that the corresponding validated signal emitted by each digital filter corresponds to a sample taken on each signal with a shift independent of the reference instant and substantially the same for all the digitisation devices.

9. A method in accordance with claim 8, characterised in that the chronological shift applied to select each series is obtained by a measurement of the time separating the instants at which validated samples are emitted and the instant at which the reference signal arrives.

**FIG.1**

**FIG.3**

## FIG.2A

## FIG.2B

FIG.4

EP 0 477 077 B1